# EUROPÄISCHE PATENTSCHRIFT

(11) **EP 3 804 482 B1**
(45) Veröffentlichungstag und Bekanntmachung des Hinweises auf die Patenterteilung: **02.08.2023**
(21) Anmeldenummer: 19729251.9
(22) Anmeldetag: 05.06.2019
(51) Int. Cl.: H05K 7/14, H05K 9/00

(54) **ELEKTRISCHES ODER ELEKTRONISCHES GERÄT UMFASSEND EIN GEHÄUSE MIT ZWEI UNTEREINANDER ELEKTROMAGNETISCH ABGESCHIRMTEN BEREICHEN**
ELECTRICAL OR ELECTRONIC DEVICE COMPRISING A HOUSING WITH TWO REGIONS SCREENED ELECTROMAGNETICALLY FROM EACH OTHER
APPAREIL ÉLECTRIQUE OU ÉLECTRONIQUE COMPRENANT UN BOÎTIER AVEC DEUX ZONES PROTÉGÉES ENTRE ELLES PAR UN BLINDAGE ÉLECTROMAGNÉTIQUE

(30) Priorität: 06.06.2018 DE 102018113409
(43) Veröffentlichungstag der Anmeldung: 14.04.2021
(73) Patentinhaber: SMA Solar Technology AG, 34266 Niestetal (DE)
(72) Erfinder: DZIUBA, Martin, 34233 Fuldatal (DE)
(86) Internationale Anmeldenummer: PCT/EP2019/064615
(87) Internationale Veröffentlichungsnummer: WO 2019/234084

(56) Entgegenhaltungen:
- DE-A1- 19 611 785

## Beschreibung

### TECHNISCHES GEBIET DER ERFINDUNG

Die Erfindung bezieht sich auf elektrisches oder elektronisches Gerät mit einem Gehäuse, das zwei untereinander elektromagnetisch abgeschirmte Bereiche aufweist. Die Bereiche können in dem gemeinsamen Gehäuse jeweils als zueinander abgeschlossene Bereiche ausgebildet sein, die untereinander keinen Luftaustausch erlauben. Alternativ ist es jedoch auch möglich, dass die Bereiche nicht abgeschlossen ausgebildet sind, sondern über Öffnungen miteinander verbunden sind, über die ein Luftaustausch zwischen den Bereichen erfolgen kann. Das elektrische oder elektronische Gerät umfasst Komponenten, beispielsweise Halbleiterschalter, die in dem Gerät mit hoher Frequenz betrieben werden und eine elektromagnetische Störstrahlung verursachen. Die Störstrahlung ist üblicherweise ein unerwünschter, im Betrieb des Geräts jedoch nicht vollständig zu vermeidender Nebeneffekt, der den Betrieb anderer Komponenten des Gerätes negativ beeinflussen kann. Zusätzlich ist die von dem Gerät nach außen emittierte Störstrahlung durch einschlägige Richtlinien / Normen begrenzt. Die Störstrahlung ist daher im Inneren des Gerätes, ggf. zusätzlich auch nach außen in die Umgebung des Gerätes, entsprechend abzuschirmen.

### STAND DER TECHNIK

Bei herkömmlichen elektrischen oder elektronischen Geräten mit zwei elektromagnetisch voneinander abgeschirmten Bereichen ist bekannt, die Abschirmung über ein in einem metallischen Gehäuse, beispielsweise in einem Druckgussgehäuse, angeordnetes metallisches Abschirmblech zu realisieren. Das Abschirmblech separiert im Innern des Gehäuses einen auf einer Seite des Abschirmblechs angeordneten ersten Bereich von einem auf einer gegenüberliegenden Seite des Abschirmblechs angeordneten zweiten Bereich. Hierzu ist das Abschirmblech auf an einer Rückwand oder einer Seitenwand des Gehäuses angebrachten Domhalterungen montiert. Über die metallisch ausgeführten Domhalterungen wird das Abschirmblech in dem Gehäuse fixiert und gleichzeitig elektrisch mit dem Gehäuse verbunden. Die abschirmende Wirkung eines derartig in dem Gehäuse befestigten Abschirmbleches ist jedoch - zumindest unter Berücksichtigung eines vertretbaren Aufwandes bei der Herstellung - nicht immer ausreichend. Dies liegt einerseits an einem vergleichsweise großen Abstand zwischen benachbarten Domhalterungen, an denen das Abschirmblech montiert ist. Der relativ große Abstand wird mit zunehmender Frequenz, i.e. abnehmender Wellenlänge, durchlässiger für das abzuschirmende hochfrequente Störsignal. Andererseits ist der lokal begrenzte elektrische Kontakt zwischen Abschirmblech und den Domhalterungen - und damit dem Gehäuse - nicht ausreichend niederimpedant ausgebildet. Eine Vergrößerung der Anzahl der Domhalterungen ist hingegen sowohl materialspezifisch als auch prozessspezifisch mit einem übermäßig erhöhten Aufwand bei der Herstellung des elektrischen Gerätes verbunden. Um bei herkömmlichen Gehäusen den Montageaufwand der Domhalterungen an die Seitenwand bzw. an die Rückwand zu vermeiden, ist es zudem bekannt, einzelne Domhalterungen während des Druckgussprozesses an die Seitenwand bzw. die Rückwand des Gehäuses anzuspritzen. Dies hat jedoch oftmals eine gesteigerte Komplexität und damit verbunden eine aufwändige Erstellung der Druckgussform zur Folge.

Die Schrift US 6,275,683 B1 offenbart eine elektromagnetische Abschirmung für ein Funktelefon umfassend einen Rahmen mit einer rechteckigen Wandstruktur und einen in den Rahmen passenden Abschirmungseinsatz, der durch Reibung, Presspassung oder Schnappverbindungen in dem Rahmen gehalten wird.

Aus der Schrift US 4,884,171 ist eine Abschirmvorrichtung mit einem Aluminium-Außengehäuse bekannt. Das Außengehäuse hat eine offene Oberseite, die mit einer leitfähigen Abdeckung verschlossen ist. Für die Verbindungen zwischen leitenden Elementen werden eng beieinanderliegende Schrauben, Oberflächen mit hoher Leitfähigkeit und EMI-Dichtungen verwendet,

Die Schrift US 2011 0063810 A1 offenbart einen rauscharmen Konverter mit einem einen Hohlraum aufweisenden Gehäuse, einer ersten und einer zweiten Leiterplatte. Auf einer Oberfläche der ersten Leiterplatte ist eine Metallschicht angeordnet. Die einen Chip aufweisende zweite Leiterplatte ist in dem Hohlraum angeordnet. Zur Abschirmung eines von dem Chip abgestrahlten elektromagnetischen Feldes ist die erste Leiterplatte auf einer den Hohlraum umgebenden Auflagefläche positioniert, wobei die Metallschicht dem Hohlraum zugewandt ist.

Die Schrift EP 1996004 A1 offenbart ein Gehäuse für einen Wechselrichter mit mindestens einer in einem Boden des Gehäuses angeordneten Vertiefung zur Aufnahme von Wickelgütern, wobei die Vertiefung durch ein Schottblech abdeckbar ist.

Die Druckschrift DE 19611785 C2 beschreibt eine elektromagnetische Abschirmvorrichtung zur Verwendung in elektronischen Geräten mit einer Schaltungsplatte, einem Chassis und einem aus elektrisch leitendem Material bestehendem Abschirmteil für elektromagnetische Wellen, das in der Nähe einer elektromagnetische Wellen erzeugenden Quelle vorgesehen ist. Das Abschirmteil weist einen Zungenbereich und einen Fußbereich auf. Das Chassis ist mit einem Schlitz versehen, in den das Abschirmteil mit seinem Zungenbereich eingeführt ist, bis sich der Zungenbereich angrenzend an die elektromagnetische Wellen erzeugende Quelle befindet, während der Fußbereich außerhalb des Chassis angeordnet ist.

### AUFGABE DER ERFINDUNG

Der Erfindung liegt die Aufgabe zugrunde, ein elektrisches oder elektronisches Gerät mit einem ersten und einem zweiten Bereich aufzuzeigen, wobei der erste Bereich relativ zu dem zweiten Bereich eine Abschirmung zur elektro-magnetischen Verträglichkeit (EMV) aufweist. Dabei ist die Abschirmung besonders einfach und kostengünstig zu realisieren. Zudem soll eine möglichst hohe Packungsdichte von Komponenten des Gerätes bei gleichzeitig hohem Freiheitsgrad in der Anordnung und Größe der abzuschirmenden Bereiche erzielt werden.

### LÖSUNG

Die Aufgabe der Erfindung wird durch ein elektrisches oder elektronisches Gerät mit den Merkmalen des unabhängigen Patentanspruchs 1 gelöst. Die abhängigen Patentansprüche 2 bis 15 sind auf bevorzugte Ausführungsformen des elektrischen oder elektronischen Geräts gerichtet.

### BESCHREIBUNG DER ERFINDUNG

Ein erfindungsgemäßes elektrisches oder elektronisches Gerät weist ein Gehäuse auf, das eine Rückwand und eine die Rückwand umfänglich umgebende Seitenwand umfasst. Das Gehäuse beinhaltet einen ersten Bereich und einen zweiten Bereich, wobei der erste Bereich gegenüber dem zweiten Bereich eine Abschirmung in Bezug auf elektro-magnetische Verträglichkeit (EMV) aufweist. Dabei weist das Gehäuse des Gerätes an einer Innenseite der Seitenwand und/oder der Rückwand einen stufenartig ausgebildeten Vorsprung auf, wobei der stufenartige Vorsprung ein integraler Bestandteil der Seitenwand beziehungsweise des Gehäuses ist. Ferner weist die Abschirmung zur elektromagnetischen Verträglichkeit ein Abschirmblech auf, mittels dessen der erste Bereich von dem zweiten Bereich abgegrenzt wird. Eine elektrische Verbindung des Abschirmblechs mit der Seitenwand und/oder mit der Rückwand ist darüber gebildet, dass ein das Abschirmblech begrenzender Randbereich zumindest entlang eines überwiegenden Teils seiner Länge den stufenartig ausgebildeten Vorsprung flächig überlappt und auf diesem befestigt ist. Das Gerät ist dadurch gekennzeichnet, dass die Rückwand des Gehäuses sowohl eine Grundfläche des ersten Bereichs, als auch eine Grundfläche des zweiten Bereichs ausbildet, wobei zumindest ein Teil des Abschirmblechs flächig auf der Rückwand aufliegt und die Rückwand hierüber direkt elektrisch kontaktiert, oder dass ein oberhalb der Rückwand in dem Gehäuse verlaufendes Metallblech sowohl eine Grundfläche des ersten Bereichs, als auch eine Grundfläche des zweiten Bereichs ausbildet, wobei zumindest ein Teil des Abschirmblechs flächig auf dem Metallblech aufliegt und das Metallblech hierüber direkt elektrisch kontaktiert.

Bei dem erfindungsgemäßen elektrischen Gerät ist es möglich, dass entlang einer beliebigen Verbindungslinie zwischen Deckel und Rückwand eine gleiche Anzahl an Bereichen angeordnet ist. Dabei kann es sich jeweils um lediglich einen oder jeweils um mehrere Bereiche handeln. Alternativ dazu ist es jedoch auch möglich, dass entlang einer ersten Verbindungslinie zwischen Deckel und Rückwand eine erste Anzahl an Bereichen, insbesondere lediglich ein Bereich, und entlang einer zweiten Verbindungslinie zwischen Deckel und Rückwand hingegen eine von der ersten Anzahl verschiedene zweite Anzahl an Bereichen, insbesondere zwei Bereiche, angeordnet sind. In beiden Fällen kann ein Teil des Abschirmblechs flächig auf der Rückwand oder auf dem oberhalb der Rückwand verlaufenden Metallblech aufliegen. Bei dem auf der Rückwand oder auf dem Metallblech aufliegenden Teil handelt es sich vorteilhafterweise um einen abgebogenen Randbereich des Abschirmbleches. Über die flächige Auflage des Abschirmblechs entsteht zwischen dem Abschirmblech und der Rückwand oder zwischen dem Abschirmblech und dem Metallblech entlang eines überwiegenden Teils des Randbereiches ein direkter und unterbrechungsfreier elektrischer Kontakt.

Sowohl die Rückwand, als auch die Seitenwand weist zu einem überwiegenden Teil ein Metall, beispielsweise Aluminium, auf. Vorteilhafterweise ist die Rückwand und die Seitenwand vollständig aus Metall gebildet. Die Rückwand und die Seitenwand können jeweils einteilig oder aber als mehrere miteinander verbundene Segmente vorliegen. Die Rückwand und die Seitenwand können lösbar oder unlösbar miteinander verbunden sein. Im letzteren Fall kann das Gehäuse als ein Gehäuse vorliegen, das beispielsweise über einen Tiefzieh- oder einen Druckgussprozess hergestellt worden ist. Das Abschirmblech ist zu einem überwiegenden Teil, vorteilhafterweise vollständig, aus Metall gebildet. Auch das Abschirmblech kann einteilig oder aber in Form mehrerer miteinander verbundener Segmente vorliegen. Gleiches gilt ebenfalls für das Metallblech. Der stufenartig ausgebildete Vorsprung weist eine zumindest bereichsweise eben ausgebildete Auflagefläche auf. Indem der das Abschirmblech begrenzende Randbereich entlang eines überwiegenden Teils seiner Länge den stufenartig ausgebildeten Vorsprung, insbesondere dessen Auflagefläche, flächig überlappt und auf diesem befestigt ist, wird dort über eine Flächenpressung ein flächig ausgebildeter elektrischer Kontakt zwischen dem Abschirmblech und der Seitenwand, dem Metallblech und/oder der Rückwand gebildet. Damit ist das Abschirmblech entlang des überwiegenden Teils seines Randbereiches durchgängig, direkt und unmittelbar mit der Seitenwand, der Rückwand und/oder dem Metallblech elektrisch verbunden. Über den flächig ausgebildeten elektrischen Kontakt werden nicht mit der Seitenwand, der Rückwand und/oder dem Metallblech verbundene Abschnitte des Randbereichs des Abschirmbleches auf ein Minimum reduziert, vorteilhafterweise sogar ganz vermieden. Hieraus resultiert eine hervorragende elektro-magnetische Abschirmung des auf einer Seite des Abschirmblechs angeordneten ersten Bereichs relativ zu dem auf der gegenüberliegenden Seite des Abschirmblechs angeordneten zweiten Bereichs. Die Abschirmung der Bereiche relativ zueinander ist deutlich besser als die der herkömmlichen Variante, bei der eine elektrische Verbindung des Abschirmblechs zur Seitenwand und/oder zur Rückwand lediglich punktuell über metallische Domhalterungen herbeigeführt wird. Gleichzeitig kann der stufenartige Vorsprung auf einfache Art und Weise an der Seitenwand, gegebenenfalls auch an der Rückwand des Gehäuses herbeigeführt werden. Konkret kann der Vorsprung beispielsweise in einem mehrstufigen Tiefziehprozess an die Seitenwand des Gehäuses angeformt werden. Sofern das Gehäuse, oder Teile des Gehäuses, über einen Druckgussprozess hergestellt wird/werden, kann der stufenartige Vorsprung in einer Druckgussform des Gehäuses bzw. an den Gehäuseteilen vorgesehen werden. Der stufenartige Vorsprung ist erfindungsgemäß somit ein integraler Bestandteil der Seitenwand bzw. des Gehäuses. Eine bei herkömmlichen Gehäusen notwendige Montage einzelner Domhalterungen an die Rückwand und oder die Seitenwand des Gehäuses entfällt. Bei dem erfindungsgemäßen Gerät ist die Ausformung des stufenartigen Vorsprungs an der Seitenwand und/oder der Rückwand der Druckgussform deutlich einfacher umsetzbar. Der stufenartige Vorsprung kann zudem auf unterschiedlichen Höhen-Niveaus entlang der Seitenwand bzw. entlang des Gehäuses verlaufen. Beispielsweise kann er einen schräg verlaufenden Anteil ausgehend von einem ersten Höhen-Niveau bis hin zu einem zweiten Höhen-Niveau des Gehäuses umfassen. Auf diese Weise ergibt sich ein großer Freiheitsgrad in einer Auslegung und Anordnung des ersten und des zweiten Bereichs relativ zueinander. Aufgrund des großen Freiheitsgrades kann eine hohe Packungsdichte von Komponenten und - damit verbunden - eine extrem kompakte Bauform des elektrischen oder elektronischen Geräts erzielt werden. Zusammenfassend ergibt sich ein zwei Bereiche aufweisendes Gerät mit einer signifikant verbesserten elektromagnetischen Abschirmung des ersten Bereichs relativ zum zweiten Bereich. Das elektrische oder elektronische Gerät lässt sich zudem kostengünstig und auf einfache Weise herstellen.

In einer vorteilhaften Ausführungsform des elektrischen oder elektronischen Geräts weist das Abschirmblech eine Ausnehmung zum Durchführen eines Kabels oder einer Busbar auf. Mittels des Kabels oder der Busbar kann eine in dem ersten Bereich angeordnete Komponente mit einer in dem zweiten Bereich angeordneten weiteren Komponente elektrisch verbunden werden. Die Ausnehmung kann an einem Randbereich des Abschirmbleches angeordnet sein. Alternativ oder kumulativ kann die Ausnehmung auch als eine Öffnung in einem innenliegenden Bereich des Abschirmbleches, mit anderen Worten abseits des Randbereiches des Abschirmblechs, ausgebildet sein. Das Abschirmblech kann zudem eine Öffnung aufweisen, an der ein Steckerteil einer Steckverbindung montiert ist. Bei dem Steckerteil kann es sich um einen männlich oder weiblich ausgeführten Steckerteil handeln. Mit dem Steckerteil kann ein komplementär ausgebildeter Gegenstecker verbunden werden, über den wiederum eine in dem ersten Bereich angeordneten Komponente mit einer in dem zweiten Bereich angeordneten weiteren Komponente elektrisch verbunden werden kann. Eine mit der Ausnehmung oder der Öffnung einhergehende geringfügige lokale Schwächung der elektromagnetischen Abschirmung kann dabei toleriert werden. Sie ist bei ausreichend geringen Abmessungen der Aussparung bzw. der Öffnung vernachlässigbar.

In einer Ausführungsform des elektrischen oder elektronischen Geräts umfasst das Gehäuse einen lösbaren Deckel, der gegenüber der Rückwand des Gehäuses angeordnet ist und an einem Rand der Seitenwand befestigt ist. In einer Variante der Ausführungsform kann der erste Bereich zwischen der Rückwand und dem Abschirmblech angeordnet sein, während der zweite Bereich auf der gegenüberliegenden Seite des Abschirmbleches zwischen dem Abschirmblech und dem Deckel angeordnet sein kann. Der erste Bereich und/oder der zweite Bereich sind somit zwischen Rückwand und Deckel zumindest teilweise, gegebenenfalls auch vollständig übereinander angeordnet.

In einer Ausführungsform des elektrischen oder elektronischen Geräts, bei dem der stufenartige Vorsprung auf der Innenseite der Seitenwand angeordnet ist, umgibt er einen Innenumfang des Gehäuses nicht nur teilweise, sondern vollständig. Dabei kann der das Abschirmblech begrenzende Randbereich den stufenartigen Vorsprung lückenlos, oder mit zumindest einer Ausnehmung als lokal begrenzte Lücke überlappen. In dieser Ausführungsform grenzt lediglich der erste Bereich an die Rückwand des Gehäuses an.

In einer weiteren Ausführungsform weist der stufenartig ausgebildete Vorsprung eine Mehrzahl von Versteifungen auf. Die Versteifungen können als lokale kegelförmige oder zylinderförmige Verdickungen der Seitenwand ausgebildet sein. Sie können sich, beginnend an der Auflagefläche des stufenartigen Vorsprungs, entlang der Seitenwand in eine Richtung senkrecht zur Rückwand entweder in Richtung auf die Rückwand hin oder von ihr weg erstrecken. Eine derartige Versteifung der Seitenwand ist insbesondere dann vorteilhaft, wenn das Gehäuse des elektrischen oder elektronischen Geräts als Druckgussgehäuse, insbesondere als Aluminium-Druckgussgehäuse ausgebildet ist. Die Versteifungen können auf einfache Art und Weise in einer Druckgussform des Druckgussgehäuses eingearbeitet sein. Sie dienen der Kraftaufnahme bei einem Lösen des Druckgussgehäuses aus der Druckgussform nach Durchführung des Druckgussverfahrens.

In einer Ausführungsform ist der stufenartig ausgebildete Vorsprung in Bezug auf eine Höhenausdehnung der Seitenwand, i.e. eine senkrecht zur Rückwand des Gehäuses orientierte Ausdehnung der Seitenwand, zumindest überwiegend in einem mittleren Höhenbereich der Seitenwand angeordnet. Dabei bezeichnet der mittlere Höhenbereich einen Bereich zwischen 20% und 80% einer jeweiligen Höhe der Seitenwand. Auf diese Weise ist in Richtung der Höhenausdehnung sowohl oberhalb als auch unterhalb des stufenartigen Vorsprungs ausreichend Raum zur Anordnung von elektrischen oder elektronischen Komponenten in dem Gerät verfügbar. Der stufenartig ausgebildete Vorsprung kann in Form einer unterschiedlichen Dicke der Seitenwand realisiert sein. Beispielsweise kann ein Teil oberhalb des stufenartigen Vorsprungs eine geringe Dicke der Seitenwand aufweisen, während ein Bereich unterhalb des stufenartigen Vorsprungs eine um den stufenartigen Vorsprung vergrößerte Dicke der Seitenwand aufweist. In einer vorteilhaften Ausführungsform ist das Gehäuse des elektrischen oder elektronischen Geräts entlang einer senkrecht zur Rückwand orientierten Gehäusedimension sowohl innenseitig als auch außenseitig stufenartig aufgebaut, so dass zu dem innenseitigen Vorsprung ein außenseitiger Vorsprung korrespondiert, der zumindest teilweise, gegebenenfalls vollständig entlang der Seitenwand des Gehäuses verläuft. Es ist auch möglich, dass das Gehäuse mehrere übereinander an der Seitenwand angeordnete stufenartige Vorsprünge aufweist. Auf diese Weise kann eine Dicke der Seitenwand über einen überwiegenden Anteil der Seitenwand auf einem für die Stabilität des Gehäuses notwendigen Minimalwert gehalten werden. Dies erlaubt eine deutliche Reduktion des notwendigen Gehäusematerials und damit eine signifikante Gewichtseinsparung.

Prinzipiell ist es möglich, dass das Abschirmblech des elektrischen oder elektronischen Geräts unlösbar mit dem stufenartigen Vorsprung verbunden ist. In einer vorteilhaften Variante hingegen ist das Abschirmblech lösbar auf dem stufenartigen Vorsprung befestigt, beispielsweise ist es dort mit dem stufenartigen Vorsprung verschraubt. Dies ermöglicht eine einfach umzusetzende nachträgliche Wartung des Gerätes insbesondere im Hinblick auf in den jeweiligen Bereichen angeordnete Komponenten. Vorteilhafterweise weist das Abschirmblech hierzu eine Entnahmevorrichtung auf, mittels der eine leichte Entnahme des Abschirmblechs aus dem Gehäuse erfolgen kann. Dabei ist die Entnahmevorrichtung geeignet, das Abschirmblech manuell oder mit einem Hilfswerkzeug zu greifen. Die Entnahmevorrichtung kann beispielsweise eine Ausnehmung, einen als Lasche umgebogenen Randbereich oder eine auf dem Abschirmblech befestigte Öse umfassen.

Konstruktionsbedingt kann es vorkommen, dass Bereiche der Seitenwand existieren, die entlang einer Höhe der Seitenwand frei von einem stufenartig ausgebildeten Vorsprung sind, obwohl das Abschirmblech auch entlang dieser Bereiche geführt wird. Ohne weitere Vorkehrungen würde somit ein Spalt zwischen der Innenseite der Seitenwand und dem dort angrenzenden Randbereich des Abschirmbleches erzeugt werden. Je nach Ausdehnung des Spaltes kann dies zu einer negativen Beeinträchtigung elektromagnetischen Abschirmung der Bereiche zueinander führen. In einer vorteilhaften Variante des elektrischen oder elektronischen Gerätes weist zumindest der Randbereich des Abschirmblechs an einem nicht mit dem stufenartigen Vorsprung flächig überlappenden Bereich einen abgebogenen Federkontakt auf, der einen an den Randbereich des Abschirmblechs angrenzenden Bereich der Seitenwand oder der Rückwand des Gehäuses federnd elektrisch kontaktiert. Auf diese Weise ist auch in einem nicht mit dem stufenartigen Vorsprung überlappenden Randbereich des Abschirmbleches noch eine ausreichende elektromagnetische Abschirmung realisierbar.

In einer Ausführungsform des elektrischen oder elektronischen Geräts weist die Rückwand und/oder die Seitenwand des Gehäuses zumindest eine Ausnehmung auf, die von einem Kühlkörper überdeckt ist. Dabei ist der Kühlkörper an einer Außenseite der Rückwand bzw. der Seitenwand angeordnet und an dieser befestigt. Bei dem Kühlkörper handelt es sich vorteilhafterweise um einen über ein Strangpressverfahren hergestellten Kühlkörper. Derartige Kühlkörper lassen sich relativ zu einem über ein Druckgussverfahren hergestellten Kühlkörper deutlich kostengünstiger produzieren. Indem der Kühlkörper die Ausnehmung überdeckt, grenzt ein Teil seiner Oberfläche an den Innenraum des Gehäuses. Auf diese Weise können Abwärme entwickelnde leistungselektronische Komponenten, beispielsweise Halbleiterschalter, direkt an den außenseitig angebrachten Kühlkörper montiert werden und somit effektiv und kostengünstig gekühlt werden.

Gemäß einer Ausführungsform ist das elektrische oder elektronische Gerät als ein Schaltwandler ausgebildet. Bei dem Schaltwandler kann es sich um einen Gleichspannungswandler (DC/DC) oder einen Wechselrichter (DC/AC) handeln. Insbesondere kann der Wechselrichter als ein Photovoltaik (PV) - Wechselrichter ausgebildet sein. Sofern das Gerät als Schaltwandler ausgebildet ist, beinhaltet der erste Bereich des Gehäuses vorteilhafterweise leistungselektronische Komponenten des Schaltwandlers, die basierend auf einem hochfrequenten Signal operieren, dieses erzeugen, oder eine Weiterleitung eines hochfrequenten Signals an weitere elektrisch angebundene Komponenten blockieren sollen. Derartige leistungselektronische Komponenten können z.B. Halbleiterschalter, eine Ansteuerschaltung für die Halbleiterschalter und/oder einen EMV Filter umfassen. Der zweite Bereich des Gehäuses weist vorteilhafterweise Verbindungskomponenten zum Anschließen des Schaltwandlers an eine eingangsseitige Stromquelle auf. Sofern der Schaltwandler als ein Wechselrichter, insbesondere als ein PV-Wechselrichter ausgebildet ist, kann die Stromquelle eine Gleichstromquelle, insbesondere einen PV-Generator beinhalten. Des Weiteren kann der zweite Bereich Verbindungskomponenten zum Anschließen des Schaltwandlers an eine Stromsenke beinhalten. Sofern der Schaltwandler einen Wechselrichter umfasst, ist die Stromsenke als Wechselstromsenke ausgebildet und kann insbesondere ein Energieversorgungsnetz beinhalten. Alternativ oder kumulativ können Trennelemente, beispielsweise Relais, in dem zweiten Bereich des Schaltwandlers angeordnet sein.

### KURZBESCHREIBUNG DER FIGUREN

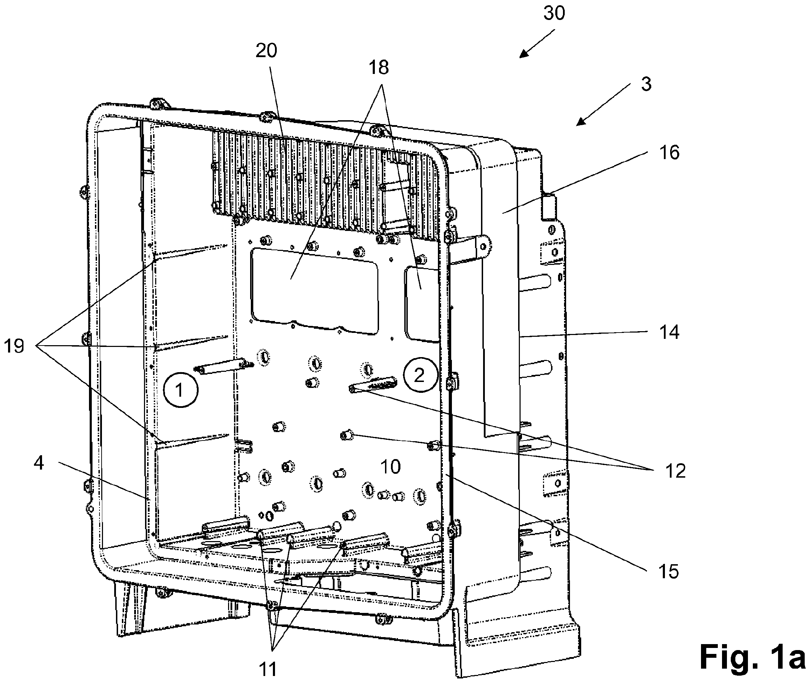

Im Folgenden wird die Erfindung anhand in den Figuren dargestellter bevorzugter Ausführungsbeispiele weiter erläutert und beschrieben. Dabei zeigen die Fig. 1a - 1d unterschiedliche Stati im Aufbau des erfindungsgemäßen elektrischen oder elektronischen Geräts. Die nachfolgende Erklärung erfolgt exemplarisch am Beispiel eines Photovoltaik (PV) - Wechselrichters als elektrisches oder elektronisches Gerät, dessen Gehäuse zwei voneinander elektromagnetisch abgeschirmte Bereiche aufweist. Die Erklärung ist jedoch nicht auf einen PV-Wechselrichter limitiert, sondern auf beliebige elektrische Geräte mit zwei voneinander elektromagnetisch abgeschirmten Bereichen übertragbar.
- **Fig. 1a**: zeigt einen frühen Status im Aufbau des erfindungsgemäßen Gerätes in einer Ausführungsform,
- **Fig. 1b**: zeigt einen relativ zu Fig. 1a fortgeschrittenen Status im Aufbau des erfindungsgemäßen Gerätes,
- **Fig. 1c**: zeigt einen relativ zu Fig. 1b weiter fortgeschrittenen Status im Aufbau des erfindungsgemäßen Gerätes,
- **Fig. 1d**: zeigt einen zeigt einen relativ zu Fig. 1c weiter fortgeschrittenen Status im Aufbau des erfindungsgemäßen Gerätes,
- **Fig. 1e**: zeigt einen nahezu finalen Status im Aufbau des erfindungsgemäßen Gerätes gemäß der Fig. 1a - 1d,
- **Fig. 2a**: zeigt einen Querschnitt durch ein erfindungsgemäßes elektrisches Gerät in einer weiteren Ausführungsform.
- **Fig. 2b**: zeigt eine Draufsicht auf das erfindungsgemäße elektrische Gerät aus Fig. 2a.

### FIGURENBESCHREIBUNG

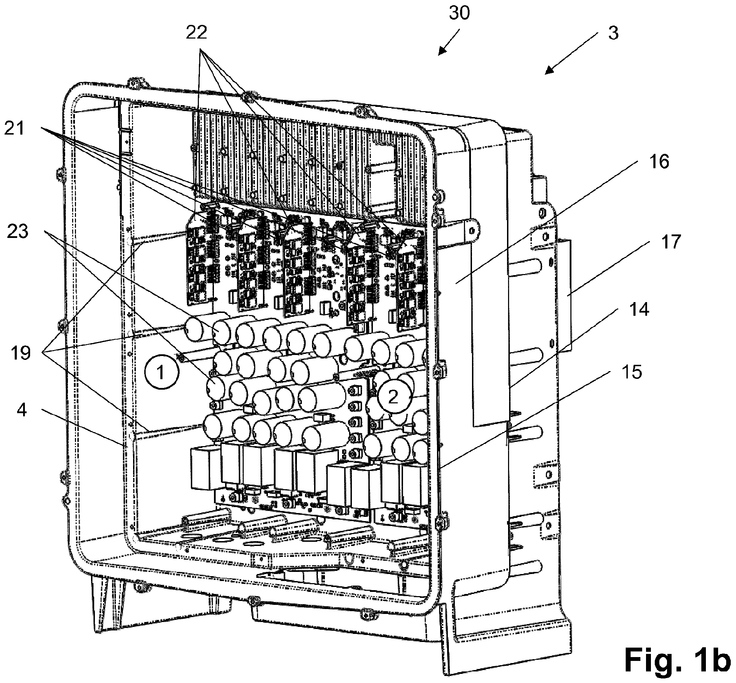

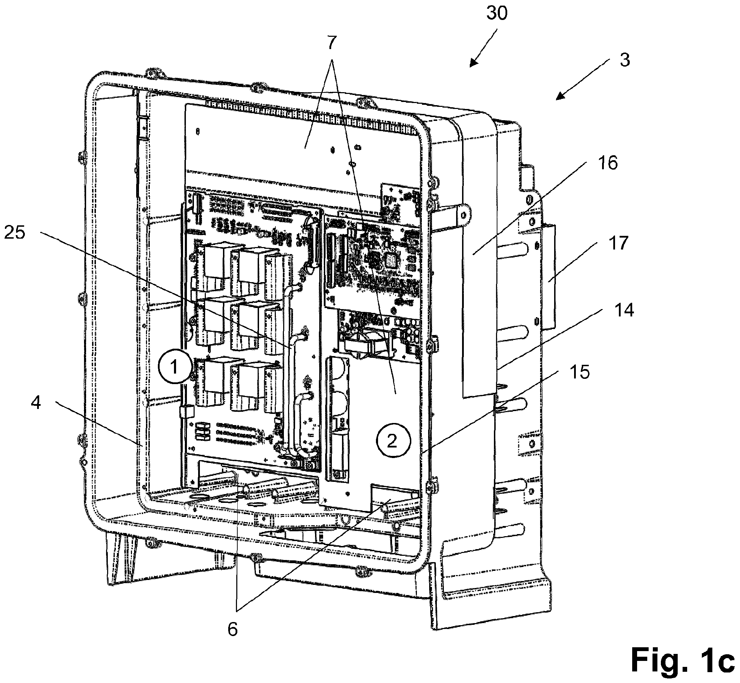

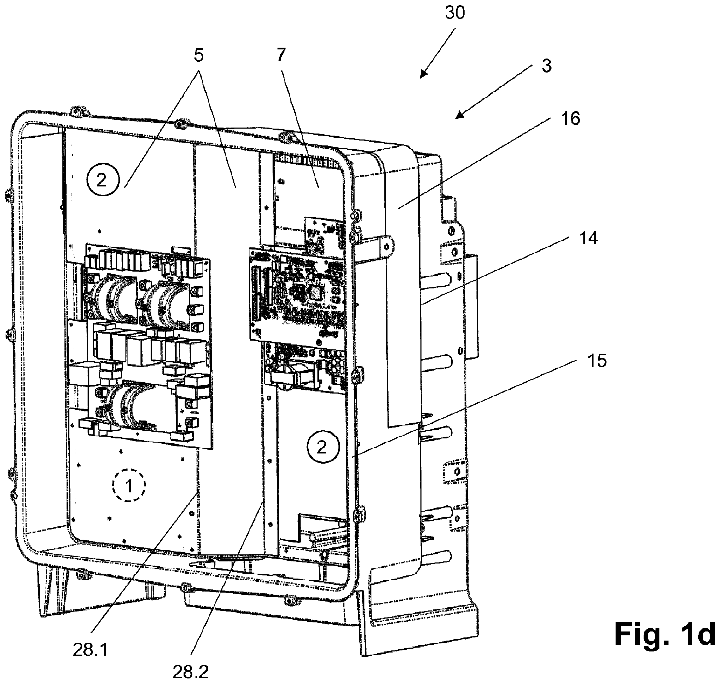

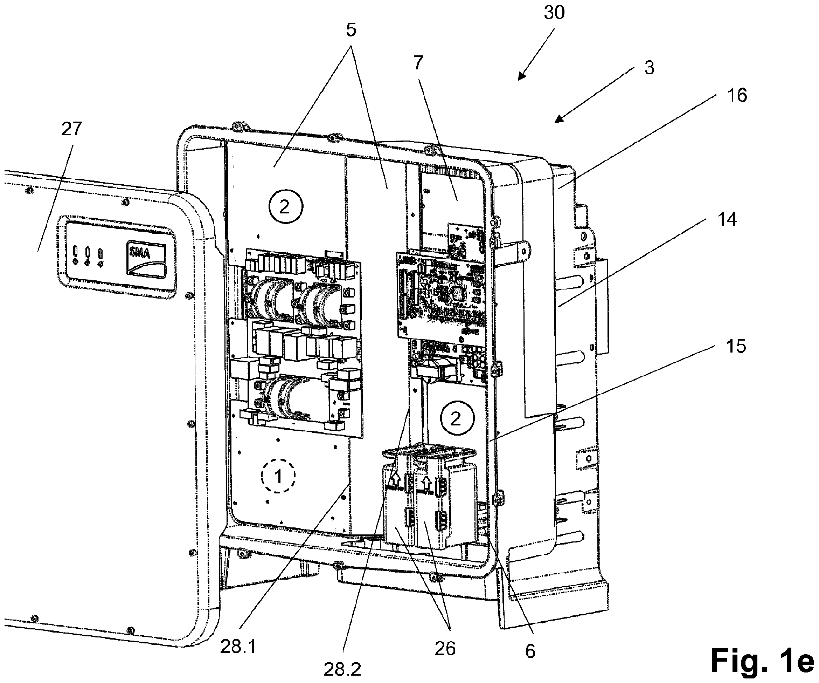

**Fig. 1a** zeigt einen frühen Aufbaustatus des erfindungsgemäßen elektrischen oder elektronischen Geräts 30 am Beispiel eines PV-Wechselrichters als Gerät 30. Das Gerät 30 beinhaltet ein als Druckgussgehäuse, insbesondere als Aluminium-Druckgussgehäuse ausgebildetes Gehäuse 3. Das Gehäuse 3 umfasst eine Rückwand 10 und eine die Rückwand 10 umfänglich umgebende und mit der Rückwand 10 verbundene Seitenwand 16. Dabei ist das in Fig. 1a dargestellte Gehäuse 3 exemplarisch quaderförmig ausgeführt. Alternativ ist jedoch auch ein Gehäuse mit einer anderen Gehäuseform, beispielsweise ein zylinderförmig aufgebautes Gehäuse möglich. Auf der Rückwand 10 sind zwei Ausnehmungen 18 angeordnet, die von einem von außen an die Rückwand montierten Kühlkörper 17 (vgl. Fig. 1b) abgedeckt werden. Der Kühlkörper 17 ist beispielhaft in Form eines aus einem Strangpressprofil hergestellten Kühlkörpers gebildet. Auf einer Innenseite der Rückwand 10 ist ein Wärmetauscher 20 angeordnet. Der Wärmetauscher 20 weist Kühlrippen auf, die sowohl in den Innenraum als auch in den Außenraum des Gehäuses 3 ragen. Er ist als integraler Bestandteil des Gehäuses 3 ausgebildet, der zusammen mit dem Gehäuse 3 über einen Druckgussprozess hergestellt wird. In Fig. 1a ist der Wärmetauscher 20 exemplarisch als Luft / Luft - Wärmetauscher ausgebildet, der Wärmeenergie eines im Innenraum über einen innenliegenden Ventilator (in Fig. 1 a nicht dargestellt) erzeugten Luftstroms an einen weiteren Luftstrom im Außenbereich des Gehäuses 3 abgibt. Dabei kann der weitere Luftstrom durch einen außenliegenden Ventilator (in Fig. 1 a nicht dargestellt) angetrieben werden, oder aber konvektiv erzeugt werden. An die Rückwand 10 sind innenseitig metallische Domhalterungen 12 zur Fixierung und elektrischen Verbindung einer Leiterplatte und/oder eines Metallblechs 7 (vgl. Fig. 1c) an das Gehäuse montiert. Weitere metallische Domhalterungen 11, die ebenfalls der Aufnahme und elektrischen Verbindung einer Leiterplatte und/oder eines Metallblechs 7 (vgl. Fig. 1c) mit dem Gehäuse 3 dienen, sind an der Seitenwand 16 montiert und elektrisch direkt mit dieser verbunden. Die Seitenwand 16 weist innenseitig einen sich über den gesamten Umfang des Gehäuses 3 erstreckenden, stufenartig ausgebildeten Vorsprung 4 auf. Der Vorsprung 4 beinhaltet eine zumindest bereichsweise eben ausgebildete Auflagefläche. Außenseitig ist ein mit dem innenseitigen Vorsprung 4 korrespondierender Vorsprung 14 angeordnet. Auch der außenseitige Vorsprung 14 verläuft entlang der Seitenwand 16 über den gesamten Umfang des Gehäuses 3. Auf diese Weise entsteht in einer zur Rückwand 10 senkrechten Richtung ein stufen- bzw. terrassenförmiger Aufbau des Gehäuses 3. Die Seitenwand 16 weist an einigen Stellen kegelförmige Versteifungen 19 auf, die sich zwischen dem Vorsprung 4 und der Rückwand 10 erstrecken. Entlang der Seitenwand 16 verläuft ein Rand 15 mit daran anschließenden Gewindebuchsen, an denen ein Deckel 27 (vgl. Fig. 1e) befestigt werden kann. Das Gehäuse 3 weist ferner einen ersten Bereich 1 und einen zweiten Bereich 2 auf. Beide Bereiche 1, 2 sind in diesem Aufbaustatus jedoch noch nicht elektromagnetisch voneinander abgeschirmt. Auch die Anordnung der Bereiche 1, 2 und deren Begrenzung zueinander sind in Fig. 1 a noch nicht erkennbar.

Fig. 1b zeigt einen relativ zur Fig. 1a weiter fortgeschrittenen Status im Aufbau des erfindungsgemäßen Gerätes 30 aus Fig. 1a. Innenseitig auf der Rückseite 10 ist eine erste Leiterplatte mit leistungselektronischen Komponenten angeordnet, die im Betrieb des elektrischen Geräts 30 hochfrequente elektrische Signale erzeugen, oder über hochfrequente elektrische Signale betrieben werden. Die aufgrund der hochfrequenten Signale erzeugte Störstrahlung ist in dem rückwandnahen Bereich des Gehäuses 3 nicht zu verhindern. Sie soll jedoch gegenüber weiteren Komponenten in einem weiter oben (hier: rückwandferner) angeordneten Bereich, und auch gegenüber der Umgebung des elektrischen Geräts 30 möglichst gut abgeschirmt werden. Die erste Leiterplatte beinhaltet mehrere Ansteuerschaltungen 22 für eine Mehrzahl von Halbleiterschaltern 21. Jeder der Halbleiterschalter 21 ist zur Kühlung im Betrieb unmittelbar auf den außenseitig am Gehäuse 3 befestigten Kühlkörper 17 montiert und daher thermisch gut an diesen gekoppelt. Die erste Leiterplatte beinhaltet ferner eine Vielzahl von einem Gleichspannungszwischenkreis des PV-Wechselrichters zugeordneten Kondensatoren 23. Der erste Bereich 1 wie auch der zweite Bereich 2 befinden sich oberhalb der ersten Leiterplatte. Auch in diesem Stadium ist der erste Bereich 1 noch nicht von dem zweiten Bereich 2 elektromagnetisch abgeschirmt und es sind noch keine Grenzen beider Bereiche 1, 2 ersichtlich.

**Fig. 1c** zeigt einen noch weiter fortgeschrittenen Status im Aufbau des Gerätes 30 aus Fig. 1b. In einer von der Rückwand beabstandeten aber parallel verlaufenden Ebene ist ein Metallblech 7 mit darauf montierten Leiterplatten angeordnet. Das Metallblech 7 ist dabei auf die Domhalterungen 11, 12 montiert und weist Ausnehmungen 6 zur Durchführung von Verbindungskabeln (in Fig. 1 c nicht dargestellt) auf. In Fig. 1c liegt das Metallblech 7 aufgrund der Ausnehmungen 6 nicht überlappend auf dem Vorsprung 4 auf. Alternativ dazu ist es jedoch auch möglich, dass das Metallblech 7 den auf gleicher Höhe verlaufenden Vorsprung 4 überlappt. Das Metallblech 7 stellt eine elektromagnetische Abschirmung für die unterhalb des Metallbleches 7 angeordneten Komponenten relativ zu den oberhalb des Metallbleches 7 angeordneten elektrischen Komponenten bereit. Wie in den folgenden Figuren 1d und 1e erklärt wird, bildet das Metallblech 7 sowohl eine Grundfläche des ersten Bereiches 1 als auch des zweiten Bereiches 2. Dabei ist der erste Bereich 1 auf der einen (hier: linken) Seite, während der zweite Bereich auf der anderen (hier: rechten) Seite oberhalb des Metallbleches 7 angeordnet ist. Im Folgenden ist es Ziel, die auf der einen (hier: linken) Seite des Metallbleches 7 angeordneten elektrischen Komponenten gegenüber den auf der anderen (hier: rechten) Seite des Metallbleches 7 angeordneten Komponenten elektromagnetisch abzuschirmen.

**Fig. 1d** zeigt einen noch weiter fortgeschrittenen Status im Aufbau des erfindungsgemäßen Gerätes 30 aus Fig. 1b. Die Komponenten auf der einen Seite des Metallbleches 7 sind über ein Abschirmblech 5 gegenüber den Komponenten auf der anderen Seite des Metallbleches 7 elektromagnetisch abgeschirmt. Der erste Bereich 1 in Fig. 1d ist somit durch das Abschirmblech 5 von dem zweiten Bereich 2 separiert. Dabei befindet sich der erste Bereich 1 zwischen dem Metallblech 7 und dem Abschirmblech 5, während der zweite Bereich 2 zwischen dem Metallblech 7 und dem Deckel 27, sowie zwischen dem Abschirmblech 5 und dem Deckel 27 angeordnet ist. (vgl. Fig. 1e) Das Abschirmblech 5 ist beispielhaft einteilig ausgebildet. Alternativ dazu ist es jedoch auch möglich, dass es aus mehreren Segmenten zusammengebaut ist, die miteinander überlappend verschraubt sind. Es ist über einen großen Teil seiner Ausdehnung eben aufgebaut, weist jedoch einen über zwei Biegekanten 28.1, 28.2 abgebogenen Bereich auf, der zwei parallel verlaufende Teilflächen miteinander verbindet. Ein Randbereich des Abschirmblechs 5 überlappt mit dem stufenartig ausgebildeten Vorsprung 4 und ist mit diesem verschraubt. Lediglich an einer Stelle an dem Randbereich des Abschirmblechs 5 sind Ausnehmungen 6 angeordnet, durch die mehrere Busbars bzw. mehrere Kabel hervortreten können. (Die Ausnehmungen sind in Fig. 1d nicht sichtbar, da sie durch eine oberhalb des Abschirmbleches 5 angeordnete weitere Leiterplatte verdeckt sind). Die Busbars und die Kabel dienen zur Verbindung von in dem ersten Bereich 1 angeordneten elektrischen Komponenten mit weiteren Komponenten, die im zweiten Bereich 2 des Gehäuses 3 angeordnet sind. In Fig. 1d ist das Bezugszeichen zu dem ersten Bereich 1 gestrichelt dargestellt, da der erste Bereich 1 unterhalb des Abschirmbleches 5 angeordnet und daher durch das Abschirmblech 5 verdeckt ist. Der zweite Bereich 2 ist oberhalb des Abschirmbleches 5 und des Metallbleches 7 angeordnet, sichtbar und daher in durchgezogener Schreibweise gekennzeichnet.

In **Fig. 1e** ist ein nahezu finaler Status im Aufbau des elektrischen oder elektronischen Gerätes 30 dargestellt. Auf diese Weise wird - abgesehen von den klein dimensionierten Ausnehmungen 6 - entlang eines überwiegenden Teils des Randbereichs ein durchgängig verlaufender direkter flächig ausgebildeter elektrischer Kontakt zwischen dem Abschirmblech 5 und der Seitenwand 16 gebildet. Zusätzlich weist ein Randbereich des Abschirmbleches 5 einen flächigen ausgebildeten elektrischen Kontakt zwischen dem Abschirmblech 5 und dem Metallblech 7 auf. Der erste Bereich 1 ist durch das flächig mit der Innenseite der Seitenwand 16 als auch flächig mit dem Metallblech 7 elektrisch verbundene Abschirmblech 5 gegenüber dem zweiten Bereich 2 in hohem Maße elektromagnetisch abgeschirmt.

In dem zweiten Bereich 2, der zwischen einem Deckel 27 des Gerätes 30 und dem Abschirmblech 5 angeordnet ist, sind unter anderem Verbindungskomponenten und Trennelemente des PV-Wechselrichters lokalisiert. Die Verbindungskomponenten können schraubbare, steckbare, oder klemmbare Verbindungselemente aufweisen. Sie können zusätzliche Schutz- oder Fixierelemente umfassen, die die Verbindungselemente relativ zueinander fixieren und deren Kurzschluss verhindern. Über die Verbindungskomponenten kann der PV-Wechselrichter eingangsseitig mit einem PV-Generator als Gleichstromquelle verbunden werden. Beispielhaft sind die eingangsseitigen Verbindungselemente als Kabelverschraubungen (in Fig. 1e verdeckt und daher nicht sichtbar) ausgebildet. Dabei werden die Kabelverschraubungen von Isolatoren 26 umgeben und über diese relativ zueinander fixiert, so dass ein einen Kurzschluss verursachender Kontakt der Kabelverschraubungen zueinander verhindert wird. Der Wechselrichter wird ausgangsseitig über AC-Klemmen (in Fig. 1e nicht dargestellt) mit einem Energieversorgungsnetz verbunden. Die Verbindung an den PV-Generator, sowie an das Energieversorgungsnetz kann weitere in Fig. 1e nicht dargestellte Trennelemente, beispielsweise Relais umfassen. Der zweite Bereich 2, wie auch das Gehäuse 3, wird von dem auf dem Rand 15 der Seitenwand 16 abdichtenden Deckel 27 abgeschlossen. Hierzu wird der Deckel 27 mit den an dem Rand 15 angeordneten Gewindebohrungen verschraubt.

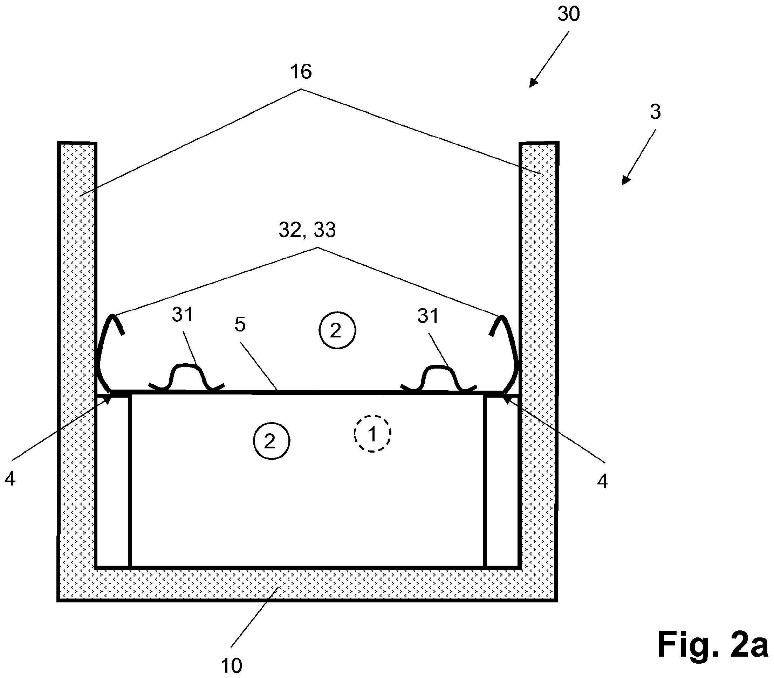

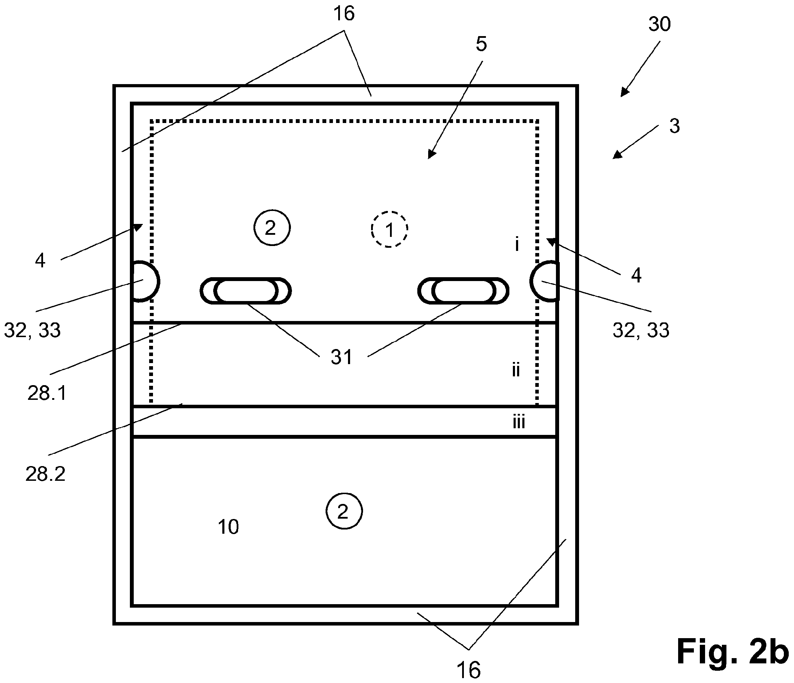

In **Fig. 2a** ist ein Querschnitt durch ein elektrisches oder elektronisches Gerät 30 in einer zweiten Ausführungsform dargestellt. In der zweiten Ausführungsform ist der erste Bereich 1 innerhalb des Gehäuses 3 zwischen der Rückwand 10 und dem Abschirmblech 5 angeordnet. Der erste Bereich erstreckt sich jedoch nicht entlang der vollständigen, sondern nur entlang eines hinteren Teils der Rückwand 10. In einem vorderen Teil der Rückwand 10 ist der zweiten Bereich 2 angeordnet. Ein Randbereich des Abschirmblechs 5 überlappt mit einem innenseitig an der Seitenwand 16 angeordneten stufenartig ausgebildeten Vorsprung 4, auf dem das Abschirmblech 5 verschraubt ist. Das Abschirmblech 5 verläuft an dem Vorsprung 4 entlang nach unten zur Innenseite der Rückwand 10, liegt dort flächig auf der Rückwand 10 auf und kontaktiert die Rückwand 10 hierdurch elektrisch. In der zweiten Ausführungsform des Gerätes 30 bildet die Rückwand 10 sowohl eine Grundfläche des ersten Bereiches 1 (in einem hinteren Bereich der Zeichenebene) als auch eine Grundfläche des zweiten Bereiches 2 (in einem vorderen Bereich der Zeichenebene). Dabei ist der zweite Bereich 2 sowohl zwischen dem Abschirmblech 5 und einem in Fig. 2 nicht dargestellten Deckel als auch zwischen der Rückwand in dem in Fig. 2 nicht dargestellten Deckel lokalisiert. Insoweit ähnelt die zweite Ausführungsform des Geräts der in den Fig. 1a-1e dargestellten ersten Ausführungsform. Bei der ersten Ausführungsform gemäß Fig. 1a-1e bildet das Metallblech 7 sowohl eine Grundfläche für den ersten Bereich 1 als auch eine Grundfläche für den zweiten Bereich 2. Bei der zweiten Ausführungsform hingegen bildet die Rückwand 10 sowohl eine Grundfläche des ersten Bereiches 1 als auch eine Grundfläche des zweiten Bereiches 2. Im Gegensatz zu den Fig. 1a - 1e wurde in Fig. 2a auf eine Darstellung der elektrischen bzw. elektronischen Komponenten verzichtet. Stattdessen sind in Fig. 2 verschiedene Varianten einer an dem Abschirmblech 5 angeordneten Entnahmevorrichtung illustriert.

Auf einer der Rückwand 10 abgewandten Seite des Abschirmblechs 5 sind zwei Ösen 31 angebracht. Jede der Ösen 31 kann entweder manuell oder mit einem Werkzeug penetriert werden, wodurch das Abschirmblech 5, nachdem es von dem stufenartig ausgebildeten Vorsprung 4 gelöst wurde, auf einfache Art und Weise nach oben hin entnommen werden kann. An zwei gegenüberliegenden Seiten des Abschirmblechs 5 sind mehrere - hier exemplarisch zwei - als Laschen 33 abgebogene Randbereiche lokalisiert. An den Laschen 33 kann das Abschirmblech 5 gegriffen werden und aus dem Gehäuse 3 entnommen werden. Vorteilhafterweise weisen die Laschen 33 hierzu an ihren Enden einen nochmals abgebogenen Bereich auf, der ein Greifen des Abschirmblechs 5 weiter vereinfacht. In Fig. 2 sind die Laschen 33 gleichzeitig als Federkontakt 32 ausgeführt, der eine Innenseite der Seitenwand 16 federnd kontaktiert. Dies ist jedoch bei der als Entnahmevorrichtung ausgeführten Lasche 33 lediglich optional und nicht zwingend erforderlich.

**Fig. 2b** zeigt die zweite Ausführungsform des elektrischen Gerätes 30 aus Fig. 2a in einer Draufsicht aus Richtung eines (in Fig. 2b nicht dargestellten) Deckels. Das auf dem Vorsprung 4 aufliegende Abschirmblech 5 weist zwei Biegekanten 28.1, 28.2 auf. Ein erster Abschnitt i des Abschirmbleches 5 verläuft in einem Abstand von und parallel zu der Rückwand 10. Zwischen den Biegekanten 28.1 und 28.2 ist ein zweiter Abschnitt ii des Abschirmbleches 5 angeordnet. Dabei verläuft der zweite Abschnitt ii schräg zur Rückwand 10 und von einem dem ersten Abschnitt i zugeordneten Höhen-Niveau des Gehäuses bis auf ein Höhen-Niveau der Rückwand 10 herab. Ein dritter Abschnitt iii des Abschirmbleches 5 verläuft wieder parallel zur Rückwand 10 und bildet einen flächigen elektrischen Kontakt mit der Rückwand 10 aus. Der sich zwischen den Biegekanten 28.1 und 28.2 erstreckende Teil des Vorsprungs 4 verläuft ebenfalls schräg zur Rückwand 10 des Gerätes, so dass das Abschirmblech 5 flächig auf dem Vorsprung 4 aufliegt. Der erste Bereich 1 ist zwischen dem Abschirmblech 5 und der Rückwand 10 angeordnet. Unterhalb des Abschirmbleches 5 erstreckt er sich über den ersten Abschnitt i und den zweiten Abschnitt ii des Abschirmbleches 5. Der zweite Bereich 2 ist in einem unteren Gehäuseabschnitt zwischen der Rückwand 10 und dem Deckel angeordnet, während er sich in einem oberen Gehäuseabschnitt zwischen dem Abschirmblech 5 und dem Deckel erstreckt.

### BEZUGSZEICHENLISTE

- 1: Bereich
- 2: Bereich
- 3: Gehäuse
- 4: Vorsprung
- 5: Abschirmblech
- 6: Ausnehmung
- 7: Metallblech
- 10: Rückwand
- 11: Domhalterung
- 12: Domhalterung
- 13: Gehäusehöhe
- 14: Vorsprung
- 15: Rand
- 16: Seitenwand
- 17: Kühlkörper
- 18: Ausnehmung
- 19: Versteifung
- 20: Wärmetauscher
- 21: Halbleiterschalter
- 22: Ansteuerschaltung
- 23: Kondensator
- 24: Busbar
- 25: Kabel
- 26: Isolator
- 27: Deckel
- 28.1,28.2: Biegekante
- 29: AC-Klemme
- 30: Gerät
- 31: Öse
- 32: Federkontakt
- 33: Lasche

## Patentansprüche

1. Elektrisches oder elektronisches Gerät (30) mit einem Gehäuse (3), das eine Rückwand (10) und eine die Rückwand (10) umfänglich umgebende Seitenwand (16) umfasst,
wobei das Gehäuse (3) einen ersten Bereich (1) und einen zweiten Bereich (2) beinhaltet und wobei der erste Bereich (1) gegenüber dem zweiten Bereich (2) eine Abschirmung in Bezug auf elektro-magnetische Verträglichkeit EMV aufweist,
wobei das Gehäuse (3) an einer Innenseite der Seitenwand (16) und/oder der Rückwand (10) einen stufenartig ausgebildeten Vorsprung (4) aufweist, wobei der stufenartige Vorsprung (4) ein integraler Bestandteil der Seitenwand (16) beziehungsweise des Gehäuses (3) ist,
wobei die Abschirmung zur elektromagnetischen Verträglichkeit ein Abschirmblech (5) aufweist, mittels dessen der erste Bereich (1) von dem zweiten Bereich (2) abgegrenzt wird, und wobei eine elektrische Verbindung des Abschirmblechs (5) mit der Seitenwand (16) und/oder mit der Rückwand (10) darüber gebildet ist, dass ein das Abschirmblech (5) begrenzender Randbereich zumindest entlang eines überwiegenden Teils seiner Länge den stufenartigen Vorsprung (4) flächig überlappt und auf diesem befestigt ist,
wobei die Rückwand (10) des Gehäuses (3) sowohl eine Grundfläche des ersten Bereichs (1), als auch eine Grundfläche des zweiten Bereichs (2) bildet, wobei zumindest ein Teil des Abschirmblechs (5) flächig auf der Rückwand (10) aufliegt und die Rückwand (10) hierüber direkt elektrisch kontaktiert, oder
wobei ein oberhalb der Rückwand (10) in dem Gehäuse (3) verlaufendes Metallblech (7) sowohl eine Grundfläche des ersten Bereichs (1), als auch eine Grundfläche des zweiten Bereichs (2) bildet, und wobei zumindest ein Teil des Abschirmblechs (5) flächig auf dem Metallblech (7) aufliegt und das Metallblech (7) hierüber direkt elektrisch kontaktiert.

2. Elektrisches oder elektronisches Gerät (30) nach Anspruch 1, **dadurch gekennzeichnet, dass** das Abschirmblech (5) eine Ausnehmung (6) zum Durchführen eines Kabels oder einer Busbar aufweist, das/die eine in dem ersten Bereich (1) angeordnete Komponente mit einer in dem zweiten Bereich (2) angeordneten weiteren Komponente elektrisch verbindet.

3. Elektrisches oder elektronisches Gerät (30) nach Anspruch 1 oder 2, **dadurch gekennzeichnet, dass** das Abschirmblech (5) eine Öffnung aufweist, an der ein Steckerteil einer Steckverbindung montiert ist.

4. Elektrisches oder elektronisches Gerät (30) nach einem der vorangehenden Ansprüche, **dadurch gekennzeichnet, dass** das Gehäuse (3) einen lösbaren Deckel (27) umfasst, der gegenüber der Rückwand (10) des Gehäuses (3) angeordnet ist und an einem Rand (15) der Seitenwand (16) befestigt ist.

5. Elektrisches oder elektronisches Gerät (30) nach Anspruch 4, **dadurch gekennzeichnet, dass** der erste Bereich (1) zwischen der Rückwand (10) und dem Abschirmblech (5) angeordnet ist, während der zweite Bereich (2) zwischen dem Abschirmblech (5) und dem Deckel (27) angeordnet ist.

6. Elektrisches oder elektronisches Gerät (30) nach einem der vorangehenden Ansprüche, **dadurch gekennzeichnet, dass** der stufenartige Vorsprung (4) auf der Innenseite der Seitenwand (16) angeordnet ist und einen Innenumfang des Gehäuses (3) vollständig umgibt, wobei optional der das Abschirmblech (5) begrenzende Randbereich den stufenartigen Vorsprung (4) lückenlos überlappt.

7. Elektrisches oder elektronisches Gerät (30) nach einem der vorangehenden Ansprüche, **dadurch gekennzeichnet, dass** das Gehäuse (3) entlang einer senkrecht zur Rückwand (10) orientierten Gehäusedimension sowohl innenseitig als auch außenseitig stufenartig aufgebaut ist, so dass zu dem innenseitigen Vorsprung (4) ein außenseitiger Vorsprung (14) korrespondiert, der zumindest teilweise entlang der Seitenwand (16) des Gehäuses (3) verläuft.

8. Elektrisches oder elektronisches Gerät (30) nach einem der vorangehenden Ansprüche, **dadurch gekennzeichnet, dass** der stufenartig ausgebildete Vorsprung (4) eine Mehrzahl von Versteifungen (19) aufweist.

9. Elektrisches oder elektronisches Gerät (30) nach einem der vorangehenden Ansprüche, **dadurch gekennzeichnet, dass** das Abschirmblech (5) lösbar auf dem stufenartigen Vorsprung (4) befestigt ist, insbesondere mit diesem verschraubt ist.

10. Elektrisches oder elektronisches Gerät (30) nach einem der vorangehenden Ansprüche, **dadurch gekennzeichnet, dass** das elektrische oder elektronische Gerät (30) als ein Wechselrichter, insbesondere als ein Photovoltaik (PV) - Wechselrichter ausgebildet ist.

11. Elektrisches oder elektronisches Gerät (30) nach Anspruch 10, **dadurch gekennzeichnet, dass** der erste Bereich (1) des Gehäuses (3) leistungselektronische Komponenten des Wechselrichters, wie z.B. Halbleiterschalter (21), eine Ansteuerschaltung (22) für die Halbleiterschalter (21) und/oder einen EMV Filter, beinhaltet,
während der zweite Bereich (2) Verbindungskomponenten zum Anschließen des Wechselrichters an eine Gleichstromquelle, insbesondere einen PV-Generator, an eine Wechselstromsenke, insbesondere ein Energieversorgungsnetz, und/oder Trennelemente, beispielsweise Relais, beinhaltet.

12. Elektrisches oder elektronisches Gerät (30) nach einem der voranstehenden Ansprüche, **dadurch gekennzeichnet, dass** das Gehäuse (3) als Druckgussgehäuse, insbesondere als Aluminium-Druckgussgehäuse ausgebildet ist.

13. Elektrisches oder elektronisches Gerät (30) nach einem der voranstehenden Ansprüche, **dadurch gekennzeichnet, dass** der Randbereich des Abschirmblechs (5) an einem nicht mit dem stufenartigen Vorsprung (4) flächig überlappenden Bereich einen abgebogenen Federkontakt (32) aufweist, der eine Seitenwand (16) oder eine Rückwand (10) des Gehäuses federnd elektrisch kontaktiert.

14. Elektrisches oder elektronisches Gerät (30) nach einem der voranstehenden Ansprüche, **dadurch gekennzeichnet, dass** die Rückwand (10) oder die Seitenwand (16) des Gehäuses (3) eine Ausnehmung (18) aufweist, die von einem Kühlkörper (17) überdeckt ist, der an einer Außenseite der Rückwand (10) oder der Seitenwand (16) angeordnet und an dieser befestigt ist.

15. Elektrisches oder elektronisches Gerät (30) nach einem der voranstehenden Ansprüche, **dadurch gekennzeichnet, dass** das Abschirmblech (5) eine Entnahmevorrichtung aufweist, mittels der eine leichte Entnahme des Abschirmbleches (5) aus dem Gehäuse (3) erfolgt, wobei die Entnahmevorrichtung eine Ausnehmung, einen als Lasche (33) umgebogenen Randbereich oder eine auf dem Abschirmblech (5) befestigte Öse (31) umfasst.

## Claims

1. An electrical or electronic device (30) with a housing (3), which comprises a rear wall (10) and a side wall (16) peripherally surrounding the rear wall (10),
the housing (3) containing a first region (1) and a second region (2) and the first region (1) comprising a shielding from the second region (2) with respect to electromagnetic compatibility EMC,
the housing (3) comprising a stepped projection (4) on an inner side of the side wall (16) and/or of the rear wall (10), wherein the stepped projection (4) is an integral part of the side wall (16) or of the housing (3), respectively,
the shielding for electromagnetic compatibility comprising a shielding plate (5), by means of which the first region (1) is delimited from the second region (2), and an electrical connection of the shielding plate (5) to the side wall (16) and/or to the rear wall (10) being formed in that a peripheral region that delimits the shielding plate (5) areally overlaps the stepped projection (4), at least along most of its length, and is fastened on it,
wherein the rear wall (10) of the housing (3) forms both a base area of the first region (1) and a base area of the second region (2), at least part of the shielding plate (5) lying flat on the rear wall (10) and thereby electrically contacting the rear wall (10) directly, or
wherein a metal plate (7) running above the rear wall (10) in the housing (3) forms both a base area of the first region (1) and a base area of the second region (2), and at least part of the shielding plate (5) lying flat on the metal plate (7) and thereby electrically contacting the metal plate (7) directly.

2. The electrical or electronic device (30) as claimed in claim 1, **characterized in that** the shielding plate (5) comprises a clearance (6) for leading through a cable or a busbar, which electrically connects a component arranged in the first region (1) to a further component arranged in the second region (2).

3. The electrical or electronic device (30) as claimed in claim 1 or 2, **characterized in that** the shielding plate (5) comprises an opening at which a connector part of a plug-in connection is attached.

4. The electrical or electronic device (30) as claimed in one of the preceding claims, **characterized in that** the housing (3) comprises a releasable cover (27), which is arranged opposite the rear wall (10) of the housing (3) and is fastened on a periphery (15) of the side wall (16).

5. The electrical or electronic device (30) as claimed in claim 4, **characterized in that** the first region (1) is arranged between the rear wall (10) and the shielding plate (5), while the second region (2) is arranged between the shielding plate (5) and the cover (27).

6. The electrical or electronic device (30) as claimed in one of the preceding claims, **characterized in that** the stepped projection (4) is arranged on the inner side of the side wall (16) and completely surrounds an inner circumference of the housing (3), optionally the peripheral region that delimits the shielding plate (5) overlapping the stepped projection (4) without any gap.

7. The electrical or electronic device (30) as claimed in one of the preceding claims, **characterized in that** the housing (3) is constructed in a stepped manner both on the inside and on the outside along a housing dimension oriented perpendicularly to the rear wall (10), so that the inner projection (4) has a corresponding outer projection (14), which runs at least partially along the side wall (16) of the housing (3).

8. The electrical or electronic device (30) as claimed in one of the preceding claims, **characterized in that** the stepped projection (4) comprises a plurality of stiffenings (19).

9. The electrical or electronic device (30) as claimed in one of the preceding claims, **characterized in that** the shielding plate (5) is releasably fastened on the stepped projection (4), in particular is screwed together with it.

10. The electrical or electronic device (30) as claimed in one of the preceding claims, **characterized in that** the electrical or electronic device (30) is formed as an inverter, in particular as a photovoltaic (PV) inverter.

11. The electrical or electronic device (30) as claimed in claim 10, **characterized in that** the first region (1) of the housing (3) contains power-electronic components of the inverter, such as for example semiconductor switches (21), a driving circuit (22) for the semiconductor switches (21) and/or an EMC filter,
while the second region (2) contains connecting components for connecting the inverter to a DC current source, in particular a PV generator, to an AC current sink, in particular an energy supply grid, and/or separating elements, for example relays.

12. The electrical or electronic device (30) as claimed in one of the preceding claims, **characterized in that** the housing (3) is formed as a diecast housing, in particular as an aluminum diecast housing.

13. The electrical or electronic device (30) as claimed in one of the preceding claims, **characterized in that** the peripheral region of the shielding plate (5) comprises at a region not areally overlapping with the stepped projection (4) a bent-away spring contact (32), that electrically contacts a side wall (16) or a rear wall (10) of the housing in a resilient fashion.

14. The electrical or electronic device (30) as claimed in one of the preceding claims, **characterized in that** the rear wall (10) or the side wall (16) of the housing (3) comprises a clearance (18), which is covered by a heat sink (17), which is arranged on an outer side of the rear wall (10) or of the side wall (16) and is fastened on it.

15. The electrical or electronic device (30) as claimed in one of the preceding claims, **characterized in that** the shielding plate (5) comprises a removal device, by means of which easy removal of the shielding plate (5) from the housing (3) takes place, the removal device comprising a clearance, a peripheral region bent around as a lug (33) or an eye (31) fastened on the shielding plate (5).

## Revendications

1. Appareil électrique ou électronique (30) avec un boîtier (3) qui comprend une paroi arrière (10) et une paroi latérale (16) entourant la paroi arrière (10) sur sa circonférence,
dans lequel le boîtier (3) comprend une première zone (1) et une deuxième zone (2) et dans lequel la première zone (1) présente un blindage par rapport à la deuxième zone (2) en ce qui concerne la compatibilité électromagnétique CEM,
le boîtier (3) présente sur un côté intérieur de la paroi latérale (16) et/ou de la paroi arrière (10) une saillie (4) en forme de gradin, la saillie (4) en forme de gradin étant une partie intégrante de la paroi latérale (16) ou du boîtier (3),
le blindage pour la compatibilité électromagnétique présente une tôle de blindage (5), au moyen de laquelle la première zone (1) est délimitée de la deuxième zone (2), et une liaison électrique de la tôle de blindage (5) avec la paroi latérale (16) et/ou avec la paroi arrière (10) est formée par le fait qu'une zone de bordure délimitant la tôle de blindage (5) recouvre à plat la saillie (4) en forme de gradin au moins le long d'une partie prépondérante de sa longueur et est fixée sur celle-ci,
la paroi arrière (10) du boîtier (3) formant aussi bien une surface de base de la première zone (1) qu'une surface de base de la deuxième zone (2), au moins une partie de la tôle de blindage (5) reposant à plat sur la paroi arrière (10) et établissant un contact électrique direct avec la paroi arrière (10) par ce biais, ou
une tôle métallique (7) s'étendant dans le boîtier (3) au-dessus de la paroi arrière (10) formant aussi bien une surface de base de la première zone (1) qu'une surface de base de la deuxième zone (2), et au moins une partie de la tôle de blindage (5) reposant à plat sur la tôle métallique (7) et établissant un contact électrique direct avec la tôle métallique (7) par ce biais.

2. Appareil électrique ou électronique (30) selon la revendication 1, **caractérisé en ce que** la tôle de blindage (5) présente un évidement (6) pour le passage d'un câble ou d'une barre bus, qui relie électriquement un composant disposé dans la première zone (1) à un autre composant disposé dans la deuxième zone (2).

3. Appareil électrique ou électronique (30) selon la revendication 1 ou 2, **caractérisé en ce que** la tôle de blindage (5) présente une ouverture sur laquelle est montée une partie de fiche d'un connecteur.

4. Appareil électrique ou électronique (30) selon l'une des revendications précédentes, **caractérisé en ce que** le boîtier (3) comprend un couvercle amovible (27) disposé en regard de la paroi arrière (10) du boîtier (3) et fixé à un bord (15) de la paroi latérale (16).

5. Appareil électrique ou électronique (30) selon la revendication 4, **caractérisé en ce que** la première zone (1) est située entre la paroi arrière (10) et la tôle de blindage (5), tandis que la deuxième zone (2) est située entre la tôle de blindage (5) et le couvercle (27).

6. Appareil électrique ou électronique (30) selon l'une des revendications précédentes, **caractérisé en ce que** la saillie en forme de gradin (4) est disposée sur le côté intérieur de la paroi latérale (16) et entoure complètement une périphérie intérieure du boîtier (3), la zone de bordure délimitant la tôle de blindage (5) chevauchant en option sans espace la saillie en forme de gradin (4).

7. Appareil électrique ou électronique (30) selon l'une des revendications précédentes, **caractérisé en ce que** le boîtier (3) est construit en gradins le long d'une dimension de boîtier orientée perpendiculairement à la paroi arrière (10), aussi bien du côté intérieur que du côté extérieur, de sorte qu'à la saillie intérieure (4) correspond une saillie extérieure (14) qui s'étend au moins partiellement le long de la paroi latérale (16) du boîtier (3).

8. Appareil électrique ou électronique (30) selon l'une des revendications précédentes, **caractérisé en ce que** la saillie (4) en forme de gradin présente une pluralité de renforts (19).

9. Appareil électrique ou électronique (30) selon l'une des revendications précédentes, **caractérisé en ce que** la tôle de blindage (5) est fixée de manière amovible sur la saillie en forme de gradin (4), en particulier est vissée sur celle-ci.

10. Appareil électrique ou électronique (30) selon l'une des revendications précédentes, **caractérisé en ce que** l'appareil électrique ou électronique (30) est conçu comme un onduleur, en particulier comme un onduleur photovoltaïque (PV).

11. Appareil électrique ou électronique (30) selon la revendication 10, **caractérisé en ce que** la première zone (1) du boîtier (3) contient des composants électroniques de puissance de l'onduleur, comme par exemple des commutateurs à semi-conducteurs (21), un circuit de commande (22) pour les commutateurs à semi-conducteurs (21) et/ou un filtre CEM,
tandis que la deuxième zone (2) comprend des composants de connexion pour raccorder l'onduleur à une source de courant continu, en particulier un générateur photovoltaïque, à un puits de courant alternatif, en particulier un réseau d'alimentation en énergie, et/ou des éléments de séparation, par exemple des relais.

12. Appareil électrique ou électronique (30) selon l'une des revendications précédentes, **caractérisé en ce que** le boîtier (3) est un boîtier moulé sous pression, en particulier un boîtier en aluminium moulé sous pression.

13. Appareil électrique ou électronique (30) selon l'une des revendications précédentes, **caractérisé en ce que** la zone de bordure de la tôle de blindage (5) présente, sur une zone ne chevauchant pas à plat la saillie (4) en forme de gradin, un contact élastique (32) replié qui établit un contact électrique élastique avec une paroi latérale (16) ou une paroi arrière (10) du boîtier.

14. Appareil électrique ou électronique (30) selon l'une des revendications précédentes, **caractérisé en ce que** la paroi arrière (10) ou la paroi latérale (16) du boîtier (3) présente un évidement (18) qui est recouvert par un dissipateur thermique (17) qui est disposé sur un côté extérieur de la paroi arrière (10) ou de la paroi latérale (16) et qui est fixé à celle-ci.

15. Appareil électrique ou électronique (30) selon l'une des revendications précédentes, **caractérisé en ce que** la tôle de blindage (5) présente un dispositif d'extraction permettant d'extraire facilement la tôle de blindage (5) du boîtier (3), le dispositif d'extraction comprenant un évidement, une zone de bord repliée sous forme de languette (33) ou un oeillet (31) fixé sur la tôle de blindage (5).
